# EUROPÄISCHE PATENTSCHRIFT

(11) **EP 1 250 605 B1**
(45) Veröffentlichungstag und Bekanntmachung des Hinweises auf die Patenterteilung: **24.03.2004**
(21) Anmeldenummer: 01911538.5
(22) Anmeldetag: 26.01.2001
(51) Int. Cl.: G01R 15/18

(54) **KOMPENSATIONSSTROMSENSOR**
COMPENSATION CURRENT SENSOR
CAPTEUR DE COURANT DE COMPENSATION

(30) Priorität: 28.01.2000 DE 10003638
(43) Veröffentlichungstag der Anmeldung: 23.10.2002
(73) Patentinhaber: Vacuumschmelze GmbH & Co. KG, 63450 Hanau (DE)
(72) Erfinder: LENHARD, Friedrich, 63452 Hanau (DE); SCHÄFER, Stefan, 55452 Rümmelsheim (DE)
(74) Vertreter: Schmuckermaier, Bernhard
(86) Internationale Anmeldenummer: PCT/EP2001/000859
(87) Internationale Veröffentlichungsnummer: WO 2001/055734

(56) Entgegenhaltungen:
- EP-A- 0 556 099
- DE-A- 3 835 101
- US-A- 5 764 123
- US-A- 5 828 282

## Beschreibung

Die Erfindung betrifft einen Kompensationsstromsensor, insbesondere zur Messung von Gleich- und Wechselströmen, bei dem das in einem Magnetkern von einer vom zu messenden Strom durchflossenen Primärwicklung erzeugte Magnetfeld durch den Kompensationsstrom in einer Sekundärwicklung kompensiert wird, wobei zur Steuerung des Kompensationsstromes mindestens eine vom Magnetfeld beeinflusste Magnetfeldsonde Abweichungen vom Nullfluss erfasst und diesen Messwert über eine Auswerteschaltung einer Verstärkeranordnung zur Erzeugung des Kompensationsstromes zuführt, während an den Ausgang der Verstärkeranordnung die Sekundärwicklung in Reihe zu einem Abschlusswiderstand angeschlossen ist, so dass am Abschlusswiderstand eine dem zu messenden Strom proportionale Spannung anliegt.

Ein derartiger Stromsensor ist beispielsweise aus der US-A-5 764 123 bekannt. Aus der DE 38 35 101A ist es zudem bekannt, Mittel vorzusehen, die einen Teil des nicht in den Magnetkern eingekoppelten Magnetflusses der Primärwicklung in die aus Sekundärwicklung und Magnetfeldsonde gebildete Kompensationseinrichtung einkoppeln und gleichzeitig den magnetischen Streufluss der Sekundärwicklung in die Kompensationseinrichtung rückkoppeln.

Kompensationsstromsensoren im allgemeinen sind zudem beispielsweise aus der EP-A-0 556 099, der US-A-5 828 282, der DE 44 23 429 A1, der DE 295 06 883 U1 und der DE 295 20 066 U1 bekannt. Ihr Funktionsprinzip ist dort eingehend beschrieben.

Je höher der zu messende Strom durch die Primärwicklung ist, umso größer ist der durch diesen Strom erzeugte Magnetfluss und umso größer ist die abschnittsweise Magnetisierung des Magnetkerns, die durch den Streufluss entsteht. Der Streufluss ist der Magnetfluss, der den Magnetkern nur teilweise durchdringt. Die Proportionalität zwischen dem Strom durch die Primärwicklung und dem Strom durch die Sekundärwicklung endet jedoch, wenn der Strom so groß ist, dass durch den Streufluss in einem Abschnitt des Magnetkerns die Sättigungsmagnetisierung des Magnetkerns erreicht wird. Der Messbereich des Stromsensors wird folglich durch die Sättigungsmagnetisierung des Magnetkerns beschränkt.

Je größer der Kernquerschnitt des Magnetkerns ist, umso größer ist der zu messende Strom, durch den die Sättigungsmagnetisierung des Magnetkerns erreicht wird, d.h. umso größer ist der Messbereich. Zur Reduzierung der Herstellungskosten und der Größe der Stromsensoren werden jedoch möglichst kleine Kernquerschnitte des Magnetkerns angestrebt.

Der Erfindung liegt die Aufgabe zugrunde, die Kompensationsstromsensoren der eingangs genannten Art dahingehend zu verbessern, dass ihr Messbereich erheblich erweitert wird, ohne die Magnetkerne und damit die Außenabmessungen nennenswert zu vergrößern.

Die Aufgabe wird durch einen Kompensationsstromsensor der eingangs genannten Art dadurch gelöst, dass Mittel vorgesehen sind, die einen Teil des nicht in den Magnetkern eingekoppelten Magnetflusses der Primärwicklung in die aus Sekundärwicklung und Magnetfeldsonde gebildete Kompensationseinrichtung einkoppeln und gleichzeitig den magnetischen Streufluss der Sekundärwicklung in die Kompensationseinrichtung rückkoppeln und dass der Kernquerschnitt des Magnetkerns in einem im Bereich der Kompensationseinrichtung befindlichen ersten Abschnitt größer ist als in einem zweiten Abschnitt des Magnetkerns ist. Durch die Einbeziehung der beiden Magnetflüsse in die Messung kann ohne Erhöhung des Bauvolumens des Kompensationsstromsensors der Messbereich drastisch erhöht werden. Durch den kleineren Kernquerschnitt im zweiten Abschnitt können die Herstellungskosten reduziert werden. Aufgrund des kleinen Kernquerschnitts kann zudem der Magnetkern als Massivteil ausgeführt sein, ohne dass zu starke Wirbelströme auftreten. Im Bereich der Magnetfeldsonde ist ein größerer Kernquerschnitt vorteilhaft, um zu verhindern, dass Fremdmagnetfelder in die Magnetfeldsonde eindringen.

Typischerweise sind als Mittel metallische Abschirmungen vorgesehen, die den Magnetkern umgeben und mit dem Magnetkern in einer Ebene liegen sowie im Bereich der Kompensationseinrichtung eine Öffnung aufweisen, so dass der Teil des Magnetflusses der Primärwicklung in die aus Sekundärwicklung und Magnetfeldsonde gebildete Kompensationseinrichtung eingekoppelt und gleichzeitig der magnetische Streufluss der Sekundärwicklung in die Kompensationseinrichtung rückgekoppelt wird.

Der Magnetkern weist bei den vorliegenden Kompensationsstromsensoren einen ersten Abschnitt auf, um den mindestens ein Teil einer Sekundärwicklung gewickelt ist. Eine Magnetfeldsonde ist im Bereich dieses ersten Abschnitts angeordnet. Die Sekundärwicklung und die Magnetfeldsonde bilden die eigentliche Kompensationseinrichtung des Kompensationsstromsensors.

Eine Primärwicklung ist über den Magnetkern mit der Sekundärwicklung magnetisch gekoppelt, wobei ein Teil des von der Primärwicklung geführten Magnetflusses nicht in den Magnetkern einkoppelt.

In einer typischen Ausgestaltung der vorliegenden Erfindung weisen die Mittel die Gestalt einer metallischen Abschirmung auf, die vom Magnetkern beabstandet ist und in einer Ebene liegt, in der der Magnetkern liegt. Diese Abschirmung umgibt den Magnetkern bis auf eine seitliche Öffnung im Bereich der Kompensationseinrichtung, wobei der die Abschirmung durchdringende Magnetfluss, der sich aus dem aus der Primärwicklung stammenden Magnetfluss und dem aus der Sekundärwicklung herrührenden Streufluss zusammensetzt, in die Magnetfeldsonde eingekoppelt wird.

Die vorstehend beschriebene Abschirmung verhindert zusätzlich eine erhöhte Abhängigkeit von äußeren Magnetfeldern. Überraschenderweise bewirkt die Abschirmung nicht nur eine geringere Fremdmagnetfeldabhängigkeit, sondern sie vergrößert den Messbereich durch die oben beschriebene Einkoppelung des Magnetflusses deutlich. Der Erfindung liegt die Erkenntnis zugrunde, dass die Abschirmung einen Teil des Streuflusses übernimmt, so dass ein dadurch entlasteter zweiter Abschnitt des Magnetkerns erst bei höheren Strömen in die Sättigung geht. Die Abschirmung wirkt wie ein weiterer Magnetkern mit einem Luftspalt, der durch den Abstand zwischen dem Magnetkern und der Abschirmung definiert ist.

Durch die Leitungen zu den Wicklungen wird die enge Kopplung zwischen den Wicklungen teilweise wieder aufgehoben. Aus konstruktiven Gründen ist ferner eine optimale Kopplung zwischen den Wicklungen nur eingeschränkt möglich. Durch die Aufhebung der engen Kopplung wird der zweite Abschnitt aufmagnetisiert und damit die Kennlinie nichtlinear, da der zweite Abschnitt nicht in der Nähe der Magnetsonde angeordnet ist und seine Magnetisierung folglich nicht notwendigerweise auf Null abgeglichen wird. Aufgrund der Abschirmung erfolgt jedoch die Aufmagnetisierung erst bei wesentlich höheren Strömen als ohne Abschirmung. Eine bessere Abschirmung gegen äußere Magnetfelder erzielt man zwar, wenn die Öffnung der Abschirmung im Bereich des zweiten Abschnitts angeordnet ist, da die Magnetsonde effektiver abgeschirmt wird. Jedoch hat sich gezeigt, dass in diesem Fall der Messbereich stark verkleinert wird. Dies liegt daran, dass der magnetische Fluss, der durch die Primärwicklung erzeugt wird, durch die Abschirmung verstärkt dem zweiten Abschnitt zugeführt wird, so dass die Sättigungsmagnetisierung schon bei sehr kleinen Strömen erreicht wird.

Der Magnetkern kann in sich vollständig geschlossen sein oder z.B. im Bereich der Magnetfeldsonde einen Spalt aufweisen. Der Magnetkern ist in der Ebene, in der der Magnetkern liegt, gebogen.

Der Magnetkern kann beispielsweise ein Ringkern sein. Der Magnetkern kann auch zum Beispiel aus zwei Bandabschnitten bestehen, die durch mehrfaches Knicken des Bandes geformt werden, was zum Beispiel in WO 98/52052 beschrieben ist.

Die Abschirmung ist vom Magnetkern beabstandet, damit die Abschirmung abschirmend wirkt. Der Abstand beträgt beispielsweise einige Millimeter.

Vorzugsweise ist die Primärwicklung um die Sekundärwicklung geführt. In diesem Fall sind also die Primärwicklung und die Sekundärwicklung auf demselben Schenkel des Magnetkerns angeordnet, so dass eine engere magnetische Kopplung der beiden Wicklungen erzielt wird und ein wesentlich kleinerer Kernquerschnitt des Magnetkerns benötigt wird, was deutlich die Herstellungskosten des Kompensationsstromsensors reduziert.

Die Abschirmung kann beispielsweise U-förmig sein. In diesem Fall erstreckt sich die Öffnung der Abschirmung entlang des gesamten ersten Abschnitts. Da außerhalb der Ebene, in der der Magnetkern liegt, keine Abschirmung vorgesehen ist, weist der Kompensationsstromsensor eine besonders kleine Größe auf.

Alternativ kann die Öffnung kleiner sein, so dass ein Teil der Abschirmung entlang dem ersten Abschnitt verläuft.

Die Abschirmung kann auch teilweise außerhalb der Ebene, in der der Magnetkern liegt, angeordnet sein. Beispielsweise weist die Abschirmung die Form eines offenen Zylinders mit Boden auf. Die Abschirmung ist also becherförmig. Auch in diesem Fall kann sich die Öffnung der Abschirmung entlang des gesamten ersten Abschnitts erstrecken. "Zylinder" ist die Bezeichnung für einen Körper, der durch zwei parallele Ebenen und eine Fläche begrenzt wird, die durch Parallelverschiebung einer Geraden längs einer Raumkurve entsteht. Die Raumkurve muss nicht unbedingt ein Kreis sein, das heißt, der Zylinder muss nicht unbedingt ein Kreiszylinder sein.

Die Abschirmung besteht vorzugsweise aus einem hochpermeablen Material. Beispielsweise besteht die Abschirmung aus Mu-Metall.

Es liegt im Rahmen der Erfindung mehr als einen Teil der Sekundärwicklung vorzusehen. Die Teile der Sekundärwicklung sind um voneinander beabstandete Abschnitte des Magnetkerns gewickelt.

Die Magnetfeldsonde ist vorzugsweise innerhalb der Sekundärwicklung angeordnet. Sie kann jedoch auch neben der Sekundärwicklung, aber in der Nähe des ersten Abschnitts des Magnetkerns angeordnet sein. Die Magnetfeldsonde kann z.B. zwischen zwei voneinander beabstandeten Teilen der Sekundärwicklung angeordnet sein.

Im folgenden wird ein Ausführungsbeispiel der Erfindung anhand der Figuren näher erläutert.
- Figur 1a: zeigt in schematischer Darstellung eine perspektivische Ansicht eines Transformators eines ersten nicht erfindungsgemäßen Kompensationsstromsensors mit einem ersten Magnetkern, einer ersten Primärwicklung, einer ersten Sekundärwicklung und einer ersten Abschirmung.
- Figur 1b: zeigt in schematischer Darstellung eine perspektivische Ansicht einer weiteren Abschirmung.
- Figur 1c: zeigt in schematischer Darstellung eine perspektivische Ansicht eines Transformators eines zweiten nicht erfindungsgemäßen Kompensationsstromsensors mit einem zweiten Magnetkern, einer zweiten Primärwicklung, einer zweiten Sekundärwicklung und einer zweiten Abschirmung.
- Figur 1d: zeigt in schematischer Darstellung eine perspektivische Ansicht eines Transformators eines dritten nicht erfindungsgemäßen Kompensationsstromsensors mit einem dritten Magnetkern, einer dritten Primärwicklung, einer dritten Sekundärwicklung und einer dritten Abschirmung.
- Figur 2: zeigt einen Querschnitt durch einen Transformator eines erfindungsgemäßen Kompensationsstromsensors mit einem vierten Magnetkern, einer vierten Primärwicklung, einer vierten Sekundärwicklung, einer vierten Magnetfeldsonde und einer vierten Abschirmung.
- Figur 3: zeigt einen Querschnitt durch einen nicht erfindungsgemäßen Kompensationsstromsensor mit einem fünften Magnetkern, einer fünften Primärwicklung, einer fünften Sekundärwicklung, einer fünften Magnetfeldsonde und einer fünften Abschirmung.
- Figur 4: zeigt die Abhängigkeit des Messfehlers vom zu messenden Strom und die Abhängigkeit der Spannung an der Sekundärwicklung vom zu messenden Strom.

Alle in den Figuren gezeigten Beispiele zeigen Kompensationsstromsensoren, die mit metallischen Abschirmungen versehen worden sind. Es wird jedoch darauf verwiesen, dass neben den metallischen Abschirmungen auch andere Ausgestaltungen möglich sind bei denen andere Mittel eingesetzt werden, um den Magnetfluss aus der Primärwicklung und den Streufluss aus der Sekundärwicklung wirksam in die Kompensationseinrichtung, insbesondere in die Magnetfeldsonde, einzukoppeln.

In den Beispielen wird nicht gezeigt und im folgenden auch nicht diskutiert, wie die von der Magnetfeldsonde erzeugten Messwerte über eine Auswerteschaltung einer Verstärkeranordnung zur Erzeugung des Kompensationsstromes zugeführt werden, während an den Ausgang der Verstärkeranordnung die Sekundärwicklung in Reihe zu einem Abschlusswiderstand angeschlossen ist, so dass am Abschlusswiderstand eine dem zu messenden Strom proportionale Spannung anliegt, da dies einerseits zum Verständnis der vorliegenden Erfindung nicht erforderlich ist und andererseits seit langem bekannt ist. Es wird dazu auf die eingangs erwähnte DE 44 23 429 A1 verwiesen.

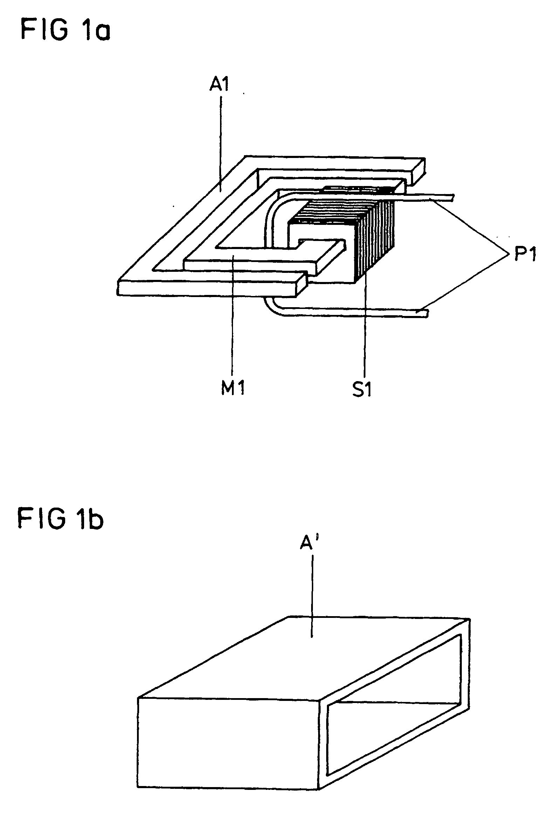

In einem ersten Beispiel weist ein erster Kompensationsstromsensor einen Transformator auf, der einen rechteckigen ersten Magnetkern M1 aufweist. Der Magnetkern M1 weist einen ersten Abschnitt auf, um den eine erste Sekundärwicklung S1 gewickelt ist (siehe Figur 1a). Innerhalb der ersten Sekundärwicklung S1 ist eine Magnetfeldsonde (nicht dargestellt) angeordnet. Gegenüber vom ersten Abschnitt ist ein zweiter unbewickelter Abschnitt des ersten Magnetkerns M1 angeordnet. Der Kernquerschnitt des ersten Magnetkerns M1 beträgt durchgängig ca. 2mm². Die Abmessungen des ersten Magnetkerns M1 betragen 20mm und 14mm.

Eine erste Primärwicklung P1 ist um die erste Sekundärwicklung S1 geführt (siehe Figur 1a). Magnetfeldlinien eines Magnetfelds, das durch einen zu messenden Strom, der durch die erste Primärwicklung P1 fließt, erzeugt wird, verlaufen teilweise entlang des ersten Magnetkerns M1 durch den zweiten Abschnitt.

Eine U-förmige erste Abschirmung A1, die vom ersten Magnetkern M1 beabstandet ist, ist derart angeordnet, dass die Öffnung der ersten Abschirmung A1, die zwischen den beiden Enden der ersten Abschirmung A1 angeordnet ist, sich entlang des ersten Abschnitts erstreckt. Der Abstand zwischen dem ersten Magnetkern M1 und der ersten Abschirmung A1 beträgt ca. 4 mm. Die erste Abschirmung A1 besteht aus Mu-Metall.

Statt der U-förmigen ersten Abschirmung A1 kann eine becherförmige Abschirmung A' vorgesehen sein, die die Form eines offenen Zylinders mit Boden aufweist. Der besseren Übersichtlichkeit halber ist in Figur 1b lediglich die becherförmige Abschirmung A' dargestellt.

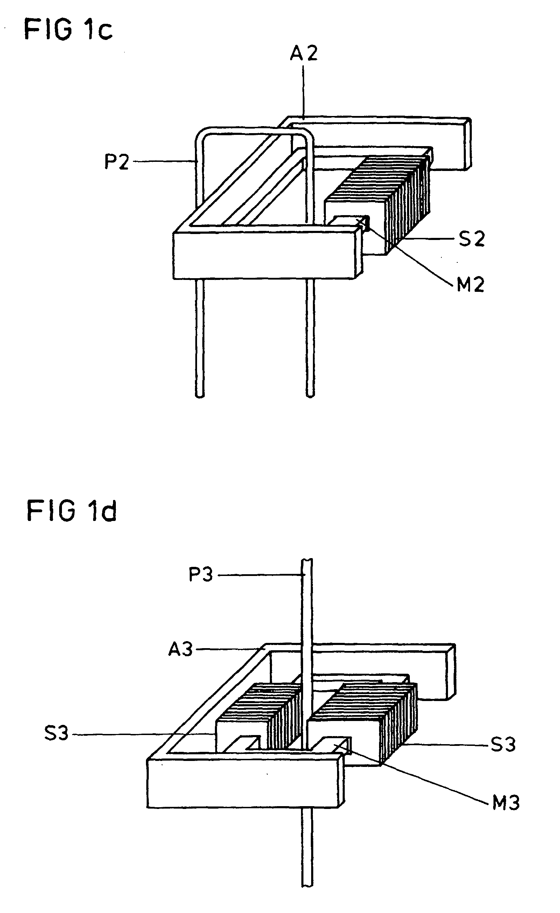

In einem zweiten Beispiel ist ein zweiter Kompensationsstromsensor vorgesehen, der einen zweiten Magnetkern M2, eine zweite Sekundärwicklung S2 und eine zweite Magnetfeldsonde (nicht dargestellt) aufweist, die wie im ersten Ausführungsbeispiel ausgestaltet sind (siehe Figur 1c).

Wie im ersten Beispiel ist eine zweite Abschirmung A2 vorgesehen, die im Vergleich zum ersten Beispiel eine größere Abmessung senkrecht zur Ebene, in der der zweite Magnetkern M2 liegt, aufweist.

Eine zweite Primärwicklung P2 ist um einen zweiten Abschnitt des zweiten Magnetkerns M2 und um die zweite Abschirmung A2 geführt. Der zweite Abschnitt des zweiten Magnetkerns M2 liegt dem ersten Abschnitt des zweiten Magnetkerns M2, um den die zweite Sekundärwicklung S2 gewickelt ist, gegenüber.

In einem dritten Beispiel ist ein dritter Kompensationsstromsensor vorgesehen, der einen dritten Magnetkern M3 und eine dritte Abschirmung A3 aufweist, die wie im zweiten Beispiel ausgestaltet sind (siehe Figur 1d).

Eine dritte Primärwicklung P3 ist als gerader Leiter ausgestaltet und durch die Mitte des dritten Magnetkerns M3 geführt.

Eine dritte Sekundärwicklung S3 weist zwei Teile auf. Der erste Teil der dritten Sekundärwicklung S3 ist um einen ersten Abschnitt des dritten Magnetkerns M3 gewickelt, entlang dem sich die Öffnung der dritten Abschirmung A3 erstreckt. Innerhalb des ersten Teils der dritten Sekundärwicklung S3 ist eine dritte Magnetfeldsonde (nicht dargestellt) angeordnet. Der zweite Teil der dritten Sekundärwicklung S3 ist um einen zweiten Abschnitt des dritten Magnetkerns M3, der dem ersten Abschnitt gegenüberliegt, gewickelt.

In einem erfindungsgemäßen Ausführungsbeispiel ist ein vierter Kompensationsstromsensor vorgesehen, der einen vierten Magnetkern M4 aufweist. Der vierte Magnetkern M4 besteht aus mehrfach gebogenen dicken Bändern. Die Biegung im Bereich eines ersten Abschnitts des vierten Magnetkerns M4 dient der Vergrößerung des effektiven Kernquerschnitts des vierten Magnetkerns M2 im Bereich des ersten Abschnitts. Dieser effektive Kernquerschnitt beträgt ca. 6mm².

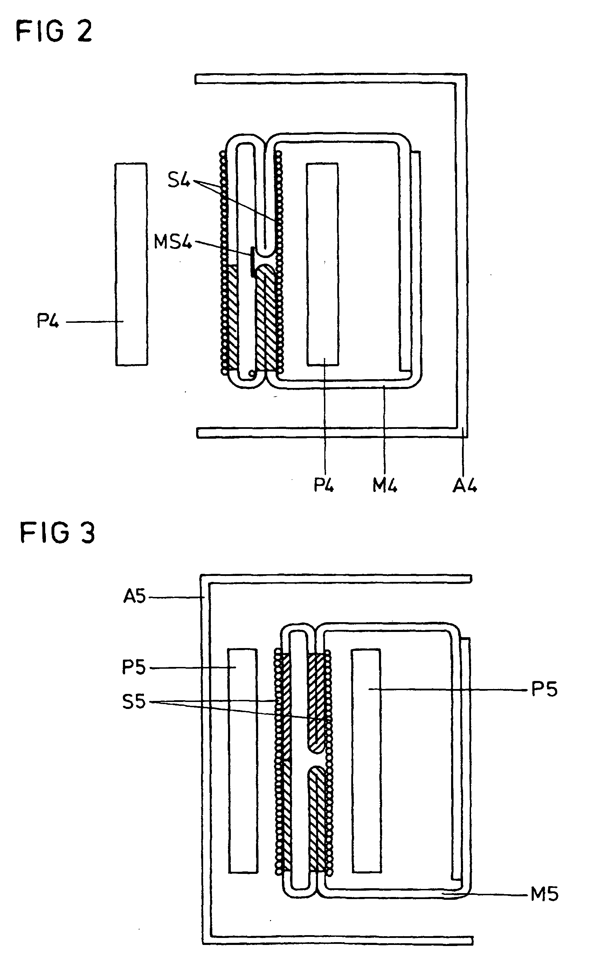

Eine vierte Sekundärwicklung S4 ist um den ersten Abschnitt gewickelt (siehe Figur 2). Innerhalb der vierten Sekundärwicklung S4 ist eine vierte Magnetfeldsonde MS4 angeordnet. Eine vierte Primärwicklung P4 wird um die vierte Sekundärwicklung S4 geführt. Gegenüber vom ersten Abschnitt ist ein zweiter Abschnitt des vierten Magnetkerns M4 angeordnet, dessen Kernquerschnitt ca. 2 mm² beträgt.

Eine U-förmige vierte Abschirmung A4 ist derart angeordnet, dass seine Öffnung sich entlang des ersten Abschnitts erstreckt (siehe Figur 2).

Ein nicht erfindungsgemäßer fünfter Kompensationsstromsensor weist einen fünften Magnetkern M5, eine fünfte Primärwicklung P5, eine fünfte Magnetfeldsonde MS5 und eine fünfte Sekundärwicklung S5 auf, die analog zum Ausführungsbeispiel nach Figur 2 angeordnet sind (siehe Figur 3). Im Gegensatz zum Ausführungsbeispiel nach Figur 2 ist eine U-förmige fünfte Abschirmung A5 so angeordnet, dass sich ihre Öffnung entlang des zweiten Abschnitts des fünften Magnetkerns M5 erstreckt.

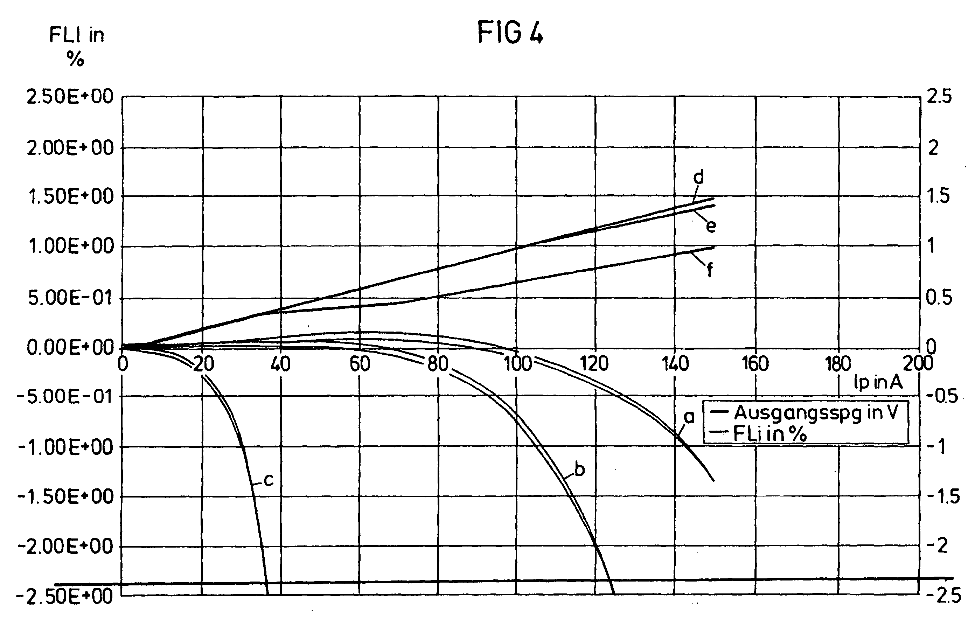

In Figur 4 ist die Abhängigkeit des Messfehlers vom zu messenden Strom, der durch die Primärwicklung fließt, für einen erfindungsgemäßen Kompensationsstromsensor gemäß Figur 2, für den nicht erfindungsgemäßen Kompensationsstromsensor gemäß Figur 3 und für einen weiteren nicht erfindungsgemäßen Kompensationsstromsensor, der analog zum Kompensationsstromsensor nach Figur 2 aber ohne Abschirmung aufgebaut ist, gezeigt. Kurve a zeigt die Abhängigkeit für den erfindungsgemäßen Kompensationsstromsensor nach Figur 2. Kurve b zeigt die Abhängigkeit für den Kompensationsstromsensor ohne Abschirmung. Kurve c zeigt die Abhängigkeit für den Kompensationsstromsensor gemäß Figur 3.

Aus Figur 4 lässt sich entnehmen, dass der Messbereich des erfindungsgemäßen Kompensationsstromsensors wesentlich größer ist als der des in Figur 3 dargestellten nicht erfindungsgemäßen Kompensationsstromsensors und des Kompensationsstromsensors ohne Abschirmung.

In Figur 4 ist ferner die Abhängigkeit der Spannung an der Sekundärwicklung von dem zu messenden Strom für den erfindungsgemäßen Kompensationsstromsensor des Ausführungsbeispiels nach Figur 2, für den nicht erfindungsgemäßen Kompensationsstromsensor gemäß Figur 3 und für den nicht erfindungsgemäßen Kompensationsstromsensor, der analog zum zweiten Kompensationsstromsensor aber ohne Abschirmung aufgebaut ist, gezeigt. Kurve d zeigt die Abhängigkeit für den Kompensationsstromsensor des Ausführungsbeispiels nach Figur 2. Kurve e zeigt die Abhängigkeit für den Kompensationsstromsensor ohne Abschirmung. Kurve f zeigt die Abhängigkeit für den nicht erfindungsgemäßen Kompensationsstromsensor gemäß Figur 3.

Der Figur 4 lässt sich entnehmen, dass die Linearität der Kennlinie des erfindungsgemäßen Kompensationsstromsensors wesentlich besser ist als der in Figur 3 dargestellte nicht erfindungsgemäße Kompensationsstromsensor und als der Kompensationsstromsensor ohne Abschirmung.

## Patentansprüche

1. Kompensationsstromsensor, bei dem der in einem Magnetkern (M1;M2;M3;M4) von einer vom zu messenden Strom durchflossenen Primärwicklung (P1;P2;P3;P4) erzeugte Magnetfluss durch den Kompensationsstrom in einer Sekundärwicklung (S1;S2;S3;S4) kompensiert wird, wobei zur Steuerung des Kompensationsstromes mindestens eine vom Magnetfluss beeinflusste und im Bereich der Sekundärwicklung befindliche Magnetfeldsonde (MS1;MS2;MS;MS4) Abweichungen vom Nullfluss erfasst und diesen Messwert über eine Auswerteschaltung einer Verstärkeranordnung zur Erzeugung des Kompensationsstromes zuführt, während an den Ausgang der Verstärkeranordnung die Sekundärwicklung in Reihe zu einem Abschlusswiderstand angeschlossen ist, so dass am Abschlusswiderstand eine dem zu messenden Strom proportionale Spannung anliegt,
**dadurch gekennzeichnet,**
**dass** Mittel vorgesehen sind, die einen Teil des nicht in den Magnetkern (M1;M2;M3;M4) eingekoppelten Magnetflusses der Primärwicklung (P1;P2;P3;P4) in die aus Sekundärwicklung (S1;S2;S3;S4) und Magnetfeldsonde (MS1;MS2;MS;MS4) gebildete Kompensationseinrichtung einkoppeln und gleichzeitig den magnetischen Streufluss der Sekundärwicklung (S1;S2;S3;S4) in die Kompensationseinrichtung rückkoppeln, und
**dass** der Kernquerschnitt des Magnetkerns (M4) in einem im Bereich der Kompensationseinrichtung befindlichen ersten Abschnitt größer ist als in einem weiteren Abschnitt des Magnetkerns (M4) ist.

2. Kompensationsstromsensor nach Anspruch 1,
**dadurch gekennzeichnet, dass**
als Mittel eine metallische Abschirmung (A1;A2;A3;A4) vorgesehen ist, die den Magnetkern (M1;M2;M3;M4) umgibt und mit dem Magnetkern (MS1;MS2;MS;MS4) in einer Ebene liegt und im Bereich der Kompensationseinrichtung eine Öffnung aufweist, so dass der Teil des Magnetflusses der Primärwicklung P1;P2;P3;P4) in die aus Sekundärwicklung (S1;S2;S3;S4) und Magnetfeldsonde (MS1;MS2;MS;MS4) gebildete Kompensationseinrichtung eingekoppelt und gleichzeitig der magnetische Streufluss der Sekundärwicklung (S1;S2;S3;S4) in die Kompensationseinrichtung rückgekoppelt wird.

3. Kompensationsstromsensor nach Anspruch 2,
**dadurch gekennzeichnet, dass** die Abschirmung (A4) u-förmig ist und dass sich die Öffnung der Abschirmung (A4) entlang des gesamten ersten Abschnitts erstreckt.

4. Kompensationsstromsensor nach Anspruch 2,
**dadurch gekennzeichnet, dass** die Abschirmung (A') die Form eines offenen Zylinders mit Boden aufweist und dass sich die Öffnung der Abschirmung (A') entlang des gesamten ersten Abschnitts erstreckt.

5. Kompensationsstromsensor nach einem der Ansprüche 1 bis 4, **dadurch gekennzeichnet, dass** die Primärwicklung (P4) um die Sekundärwicklung (S4) geführt und von der Sekundärwicklung (S4) elektrisch isoliert ist.

## Claims

1. Compensation current sensor, in which the magnetic flux which is produced in a magnet core (M1; M2; M3; M4) by a primary winding (P1; P2; P3; P4) in which the current to be measured flows is compensated for by the compensation current in a secondary winding (S1; S2; S3; S4), with at least one magnetic field probe (MS1; MS2; MS; MS4) which is influenced by the magnetic flux and is located in the area of the secondary winding detecting differences from the zero flux for control of the compensation current and supplying this measured value via an evaluation circuit to an amplifier arrangement in order to produce the compensation current, while the secondary winding is connected in series with a terminating resistance to the output of the amplifier arrangement, so that a voltage which is proportional to the current to be measured is produced across the terminating resistance,
**characterized**
**in that** means are provided which inject a portion of the magnetic flux, which is not injected into the magnet core (M1; M2; M3; M4), of the primary winding (P1; P2; P3; P4) into the compensation device which is formed from the secondary winding (S1; S2; S3; S4) and from the magnetic field probe (MS1; MS2; MS; MS4), and at the same time feed back the stray magnetic flux from the secondary winding (S1; S2; S3; S4) into the compensation device, and
**in that** the core cross section of the magnet core (M4) in a first section that is located in the area of the compensation device is larger than a further section of the magnet core (M4).

2. Compensation current sensor according to Claim 1,
**characterized in that**
a metallic screen (A1; A2; A3; A4) is provided as the means, surrounds the magnet core (M1; M2; M3; M4) and lies in a plane with the magnet core (MS1; MS2; MS; MS4) and, in the area of the compensation device, has an opening so that the portion of the magnetic flux of the primary winding (P1; P2; P3; P4) is injected into the compensation device which is formed from the secondary winding (S1; S2; S3; S4) and from the magnetic field probe (MS1; MS2; MS; MS4) and, at the same time, the stray magnetic flux from the secondary winding (S1; S2; S3; S4) is fed back into the compensation device.

3. Compensation current sensor according to Claim 2,
**characterized in that** the screen (A4) is u-shaped, and
**in that** the opening in the screen (A4) extends along the entire first section.

4. Compensation current sensor according to Claim 2,
**characterized in that** the screen (A') is in the form of an open cylinder with a base, and **in that** the opening in the screen (A') extends along the entire first section.

5. Compensation current sensor according to one of Claims 1 to 4,
**characterized in that** the primary winding (P4) is passed around the secondary winding (S4) and is electrically isolated from the secondary winding (S4).

## Revendications

1. Capteur de courant de compensation, dans lequel un flux magnétique créé dans un noyau magnétique d'un bobinage primaire (P1 ; P2 ; P3 ; P4) traversé par le courant à mesurer est compensé par le courant de compensation d'un bobinage secondaire (S1 ; S2 ; S3 ; S4), dans lequel, pour la commande du courant de compensation, au moins une sonde de champ magnétique (MS1 ; MS2 ; MS ; MS4) influencée par le flux magnétique, disposée dans la zone du bobinage secondaire, saisit des déviations par rapport au flux nul et dirige cette valeur de mesure au travers d'un circuit d'exploitation à une disposition d'amplificateur pour la génération du courant de compensation, alors qu'au niveau de la sortie de la disposition d'amplificateur est raccordé le bobinage secondaire en série avec une résistance de terminaison, si bien qu'au niveau de la résistance de terminaison figure une tension proportionnelle au courant à mesurer,
**caractérisé en ce que**
des moyens sont prévus qui couplent une partie du flux magnétique non couplé dans le noyau magnétique (M1 ; M2 ; M3 ; M4) du bobinage primaire (P1 ; P2 ; P3 ; P4) avec le dispositif de compensation formé du bobinage secondaire (S1 ; S2 ; S3 ; S4) et de la sonde de champ magnétique (MS1 ; MS2 ; MS ; MS4) et, simultanément, couple en retour le flux magnétique de fuite du bobinage secondaire (S1 ; S2 ; S3 ; S4) avec le dispositif de compensation, et la section transversale de noyau du noyau magnétique (M4) est plus grande dans une première section se trouvant dans la zone du dispositif de compensation que dans une autre section du noyau magnétique (M4).

2. Capteur de courant de compensation selon la revendication 1,
**caractérisé en ce qu'**
on prévoit comme moyen un blindage métallique (A1 : A2 ; A3 ; A4) qui entoure le noyau magnétique (M1 ; M2 ; M3 : M4) et qui se trouve avec le noyau magnétique (MS1 ; MS2 ; MS ; MS4) en un plan tel et présente dans la zone du dispositif de compensation, une ouverture telle qu'une partie du flux magnétique du bobinage primaire (P1 ; P2 ; P3 ; P4) est couplée avec le dispositif de compensation formé du bobinage secondaire (S1 ; S2 ; S3 ; S4) et la sonde de champ magnétique (MS1 ; MS2 ; MS et MS4) et, simultanément, couple en retour le flux magnétique de fuite du bobinage secondaire (S1 ; S2 ; S3 ; S4) dans le dispositif de compensation.

3. Capteur de courant de compensation selon la revendication 2,
**caractérisé en ce que**
le blindage (A4) est en forme de U et l'ouverture du blindage (A4) s'étend le long de la totalité de la première section.

4. Capteur de courant de compensation selon la revendication 2,
**caractérisé en ce que**
le blindage (A') présente la forme d'un cylindre ouvert avec fond et l'ouverture du blindage (A') s'étend le long de la totalité de la première section.

5. Capteur de courant de compensation selon l'une quelconque des revendications 1 à 4,
**caractérisé en ce que**
le bobinage primaire (P4) est conduit autour du bobinage secondaire (S4) et est isolé électriquement du bobinage secondaire (S4).
